Europäisches Patentamt

European Patent Office

Office européen des brevets

(19)

(11) **EP 1 096 676 A1**

(12) **EUROPEAN PATENT APPLICATION**

(43) Date of publication:
    **02.05.2001 Bulletin 2001/18**

(51) Int Cl.⁷: **H03K 3/03**

(21) Application number: **99830668.2**

(22) Date of filing: **25.10.1999**

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI**<br><br>(71) Applicant: **STMicroelectronics S.r.l.**<br>**20041 Agrate Brianza (Milano) (IT)** | (72) Inventor: **Poletto, Vanni**<br>**15033 Casale Monferrato (AL) (IT)**<br><br>(74) Representative: **Mittler, Enrico**<br>**c/o Mittler & C. s.r.l.,**<br>**Viale Lombardia, 20**<br>**20131 Milano (IT)** |

(54) **Oscillator with elevated precision and stability**

(57)     The present invention refers to an oscillator of the type using digital inverter circuits. In an embodiment the oscillator comprises:

-    a first inverter (20) having a first input and a first output;
-    a second inverter (21) having a second input and a second output; said first output being coupled to said second input;
-    a first capacitor (C) applied between said second output and said first input;
    characterized by further comprising
-    a first current generator (22) generating a first prefixed current able to charge said capacitor responsive to a first control signal;
-    a second current generator (25) generating a second prefixed current able to discharge said capacitor responsive to a second control signal;

said first and second control signal being complementary.

Fig. 2

## Description

The present invention refers to an oscillator of the type using digital inverter circuits.

They are known circuits using one or more inverters, or analogous logical circuits, to carry out oscillators the working frequency of which is determined mainly from capacitors and resistances properly connected to the inverters.

The working frequency of such oscillators depends, beyond that from the applied resistances and capacitors, from the threshold voltage of the used logical circuits.

The threshold voltage of the logical circuits can vary and it is different from a logical circuit to an other, therefore the working frequency can not be determined with precision.

In view of the state of the art described, it is an object of the present invention to provide a precision oscillator the working frequency of which doesn't depend on the threshold voltage of the used logical circuits.

According to the present invention, such object is attained by means of an oscillator comprising:

- a first inverter having a first input and a first output;
- a second inverter having a second input and a second output; said first output being coupled to said second input;
- a first capacitor applied between said second output and said first input;

  characterized by further comprising

- a first current generator generating a first prefixed current able to charge said capacitor responsive to a first control signal;
- a second current generator generating a second prefixed current able to discharge said capacitor responsive to a second control signal;

  said first and second control signal being complementary.

Thanks to the present invention it is possible to carry out a precision oscillator the working frequency of which doesn't depend on the threshold voltage of the used logical circuits, because the charging and discharging current of the capacitor that determines the working frequency is independent from the threshold voltage of the logical circuits.

The features and the advantages of the present invention will be made more evident by the following detailed description of a particular embodiment, illustrated as a non-limiting example in the annexed drawings, wherein:

figure 1 represents an oscillator scheme according to the known art;
figure 2 represents a basic oscillator scheme according to the present invention;
figure 3 shows the waveforms in any knots of the circuit of figure 2;
figure 4 represents a simplified scheme of an embodiment of an oscillator according to the present invention.

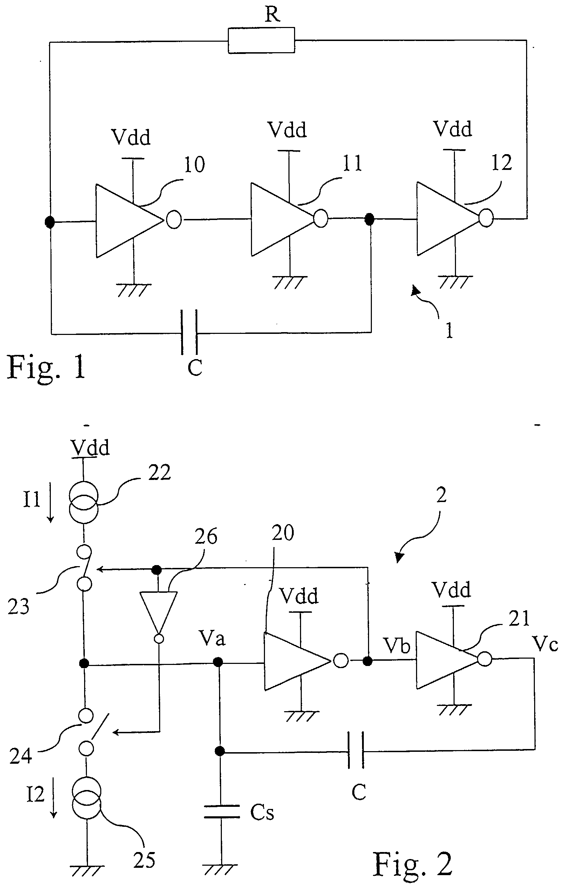

In figure 1 is shown a scheme of an oscillator 1 according to the known art, which comprises a first 10 a second 11 and a third 12 inverter connected in series between them, and fed between Vdd and ground. A capacitor C is connected between the input of the first 10 inverter and the input of the third 12 inverter, and a resistance R is connected between the output of the third 12 inverter and the input of the first 10 inverter.

The oscillation period T of the oscillator circuit 1 is determined by the charging and discharging time of the capacitor C through the resistance R.

It can be proved that the two oscillator semiperiods T1 and T2 are given by the following formulas:

$$T1 = RC \ln\left(\frac{2 - Vtha/Vdd}{1 - Vtha/Vdd}\right) \qquad T2 = RC \ln\left(\frac{1 - Vtha/Vdd}{Vtha/Vdd}\right)$$

where Vtha represents the threshold voltage of the first 11 inverter.

As it is possible to see both the semiperiods T1 and T2 depend on the threshold voltage value of the inverter. As it is known that the threshold voltage of a logical circuit depends on many factors, among which the temperature, the doping of the input circuits and it varies also from circuit to circuit because of the manufacture tolerances.

In the circuit of figure 1, in the instants of commutation, the input voltage of the first 10 inverter it is equal to the threshold voltage Vtha added to the voltage, positive or negative, present at that time to the heads of the capacitor C that it is equal in absolute value to Vdd. The input voltage of the first 10 inverter, at the starting of each semiperiod, it will be therefore equal to Vtha+Vdd or Vtha-Vdd, therefore overcome the supply voltages of Vdd and ground, unless there are limiting diodes to avoid such drawback.

In figure 2 it is represented a basic scheme of an oscillator 2 according to the present invention that comprises a first 20 inverter and a second 21 inverter connected in series, fed between Vdd and ground. A first capacitor C is connected between the input of the first 20 inverter and the output of the second to 21 inverter. Preferably, a second capacitor Cs is connected between the input of the first 20 inverter and ground.

A first current generator 22, delivering. a current I1, has a terminal connected to the supply Vdd and the other terminal is connected in series to a first controlled switch 23, which in turn is connected to the input of the first 20 inverter.

A second current generator 23, delivering a current I2, has a terminal connected to ground and the other terminal is connected in series to a second controlled switch 24, which in turn is connected to the input of the first 20 inverter.

A signal is taken from the output of the 20 inverter first and it is used to control the first switch 23 directly, the same signal complementaried through a third 26 inverter is used to control the second switch 24. When the signal is taken from the output of the first 20 inverter is in a high logical level the first switch 23 is closed and the second switch 24 is opened.

In this way the first 22 and the second 23 current generator deliver the charging and discharging current of the capacitor C controlled by the logical level available to the output of the first 20 inverter.

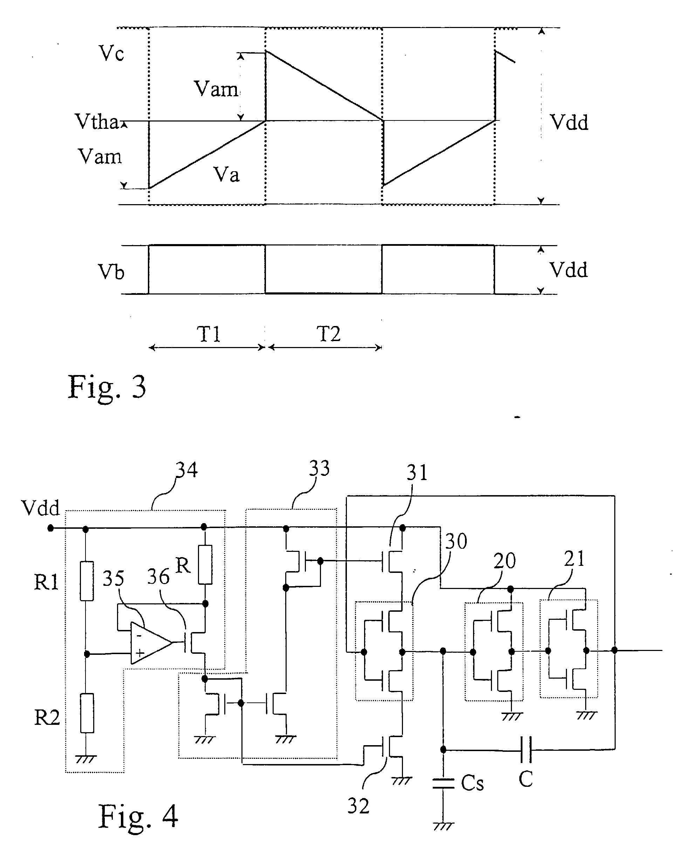

Referring to figure 3 it can be seen that during the semiperiod T1 of charging of the capacitor C, the voltage Va at the input of the first 20 inverter, it is a increasing voltage ramp. In the moment in which it reaches and overcome the threshold voltage Vtha of the first 20 inverter, the first 20 inverter switches, consecutively switches also the second 21 inverter. At this point, at the output of the second 21 inverter it will be present a high value logical Vc equals to the Vdd voltage; that it is reflected on the voltage Va through the capacitor divider C and Cs with positive voltage jump, that it is to be added to the voltage Va, and equals to

$$Vam = Vdd * \left(\frac{C}{C+Cs}\right)^{-}$$

The event that provokes the switching of the inverters, and particularly the Vb voltage at the output of the second 20 inverter, causes the opening of the first switch 23 and the closing of the second switch 24, and that is the interruption of the current I1 of charging of the capacitor C and the deliver of the current I2 of discharge. At this point the second semiperiod T2 starts in which the voltage Va is a descent ramp, that will stop when it has become lesser than the threshold voltage Vtha.

The values of the two semiperiods T1 and T2 have been given by the following relationships.

$$T2 = \frac{Vam}{I2}(C+Cs) = \frac{Vdd}{I2}C \qquad T1 = \frac{Vam}{I1}(C+Cs) = \frac{Vdd}{I1}C$$

In the case in which I1 and I2 are equal it is T1= T2= T.

It is to be noted as the two semiperiods T1 and T2 are independent from the voltage threshold Vtha of switching of the first 20 inverter and besides they are independent from the capacitor Cs.

The two semiperiods T1 and T2 are instead sensitive to the delay, not considered in the above formulas, with which the first 20 inverter switches its own output starting from the moment in which the input voltage Va is crossing upwards or downwards the Vtha threshold.

The first 20 inverter effects the function of threshold comparator. Each threshold comparator requires an overdrive (overdrive) which represents that voltage value for which the theoretical threshold value must be overcome to get the complete switching of the output of the comparator itself. This overdrive is necessary to the input stage of the comparator for generating those current that must charge the inevitable stray capacitors associated to those knots, inside the comparator, whose voltage must vary. The overdrive can be reduced increasing the gm (variation of current divided by variation of the input voltage) of the input stage in order to get large current with small overvoltage. The overdrive can be also reduced simplifying the circuit structure of the comparator with consequent reduction of the stray capacitors.

Both these arrangements carry inevitably to a threshold value not very controllable in absolute value.

The overdrive of a comparator used. in an oscillator introduces, therefore, an error in the oscillation frequency because lengthens the times T1 and T2 of a variable quantity with the manufacture process and with the working conditions (temperature most of all), therefore it is opportune to take all the useful arrangements to reduce it.

An oscillator according to the present invention, the period of which doesn't depend on the threshold voltage, can allows or does not allow the precision respects the comparator speed of the threshold comparator, it is in fact possible to design a comparator, with known techniques, in which speed take advantage over precision. Thanks to this greater speed the overdrive problem is minimized.

In figure 4 a simplified scheme of an embodiment of an oscillator according to the present invention is represented.

To be noted the inverter 20 and 21, represented in this case by means of two MOS transistors, and the capacitors C and Cs already present in figure 2.

The switches 23 and 24 of figure 2 are preferably carried out by means of a further inverter 30, the current generators 22 and 25 of figure 2 are preferably carried out by means of two MOS transistors and respectively referred with the reference 31 and 32. Such transistors 31 and 32 deliver the current I1 and I2, in this embodiments they are identical, and are controlled by means of a current mirror 33, which is in turn is driven by a current generator 34.

The current generator 34 comprises a resistive divider connected between the voltage supply Vdd and ground constituted of two resistances R1 and R2 which deliver a reference voltage to an operational amplifier 35. The operational amplifier 35, working as voltage follower, drives a MOS transistor 36 (in this case of P type), whose source is connected to the voltage supply Vdd through a R resistance, and the drain is connected to a MOS transistor of the current mirror 33.

The figure 4 shows as for instance the two switches 23 and 24 carried out by means of the two MOS transistors that constitute the inverter 30.

Such MOS transistors have the body terminal normally connected to Vdd, for the pmos type, or to ground, for the nmos type. This configuration involves the presence of stray diodes that don't allow to the Va voltage, at the input of the first 20 inverter, to go above the Vdd voltage or below the ground voltage.

When the Va voltage is next to the supply voltages (Vdd and ground) the stray diodes become active and therefore a fraction of the current I1 or I2 will flow in the diodes. In this way the charging and discharging current of the capacitor C results altered from the current flowing in the stray diodes.

Placing the capacitor Cs between Va and ground (but it can also be connected between Va and Vdd) limits the voltage step to be applied to Va. The Vam value delivered by the divider C and Cs is calculated so that, this value added or subtracted from the Vtha threshold value, never overcomes Vdd or ground, getting in this way a precise charging and discharging current of the Va voltage not altered by the activation of the stray diodes, the current of which would alter the oscillator period in a not very predictable way.

A further reason to limit the Va voltage value is that the oxide with which the transistors input gate of the inverters is manufactured would result periodically stressed by voltage values higher than all the other transistors. That would involve a technological over dimensioning of all the oxides to support the over voltage, with a performances degrade of all those transistors not interested by such over voltage. As alternative it would require an increasing of technological complexity to build two different oxides, one for the normal voltages and an other appropriate one for the input transistors of the inverter.

The resistances R1, R2 and R determine the current I delivered by the current generator 34, in fact

$$\alpha Vdd = Vdd \frac{R2}{(R1+R2)}$$

$$I = \frac{\alpha Vdd}{R}$$

Being the current I1= I2= I it is that
It can be seen therefore that the period could be linearly controlled by

$$T1 = T2 = T = \frac{Vdd}{I} C = \frac{RC}{\alpha}$$

the Vdd voltage. The oscillation frequency can be linearly controlled by the current I. The length of the two semiperiods T1 and T2 could be eventually controlled by two currents I1 and I2 generated by two separate current generators.

The oscillation period can also be made independent by the supply voltage Vdd through the uses of the R, R1 and R2 resistances, generating charging and discharging current proportional (α factor) to the voltage supply.

The technological variations of the capacitor C of the resistance R, from which the frequency of oscillation depends, can be recovered controlling, by calibrating the value of R or the value of R1 and R2 and therefore the factor a.

If the resistance R has a known dependence on the temperature, like it happens in the integrated technology, a recovery would be possible in a known way for instance selecting an operational amplifier 35 having an input offset which varies with the temperature.

The oscillator can be carried out with integrated technology using only an external component (the resistance R) getting in this way an elevated stability at the varying of the temperature and the VDD (variation of frequency lesser than 1% in the normal use conditions in which Vdd changes of the ±10% and the temperature change from- 40°C to + 150°C).

The extreme rapidity of switching of the first 20 inverter with function of threshold comparator, allows a use, of the oscillator according to the present invention, up to frequencies moderately elevated (10 MHz), in which good stability and linearity characteristics are still guaranteed.

## Claims

1. Oscillator comprising:

   - a first inverter having a first input and a first output;
   - a second inverter having a second input and a second output; said first output being coupled to said second input;
   - a first capacitor applied between said second output and said first input;

   characterized by further comprising

   - a first current generator generating a first prefixed current able to charge said capacitor responsive to a first control signal;
   - a second current generator generating a second prefixed current able to discharge said capacitor responsive to a second control signal;

   said first and second control signal being complementary.

2. Oscillator according to claim 1 characterized in that said first and second generator are connectable to said first input through two switches controlled from said first and second control signal.

3. Oscillator according to claim 1 characterized in that said two switches are essentially constituted by a third inverter having a third input, connected to said second output, and a third output connected to said first input.

4. Oscillator according to claim 3 characterized in that said third inverter is connected to a first supply voltage through said first current generator and to a second supply voltage through said second current generator.

5. Oscillator according to claim 1 characterized by comprising a second capacitor connected between said first input and a supply voltage.

6. Oscillator according to claim 1 characterized in that said first and second generator comprises a current generator, a positive current mirror generating a current able to charge said capacitor, and a negative current mirror generating a current able to discharge said capacitor.

7. Oscillator according to claim 1 characterized in that said first and second generator deliver a current proportional to the supply voltage.

8. Oscillator according to claim 1 characterized in that said first and second generator are calibrated.

9. Oscillator according to claim 1 characterized in that said first and second prefixed currents are equal.

10. Oscillator according to claim 1 characterized in that said first and second prefixed currents are independent from the threshold voltage of said inverters.

Fig. 1

Fig. 2

Fig. 3

Fig. 4

# EUROPEAN SEARCH REPORT

European Patent Office

Application Number

EP 99 83 0668

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | PATENT ABSTRACTS OF JAPAN vol. 009, no. 035 (E-296), 14 February 1985 (1985-02-14) & JP 59 178014 A (NISSAN JIDOSHA KK), 9 October 1984 (1984-10-09) * abstract * | 1-7,10 | H03K3/03 |
| Y | --- | 8 | |
| Y | US 5 359 301 A (CANDAGE ANTHONY B) 25 October 1994 (1994-10-25) * column 7, line 21 - column 9, line 40; figures 5,6 * ----- | 8 | |

TECHNICAL FIELDS SEARCHED (Int.Cl.7)

H03K

The present search report has been drawn up for all claims

| Place of search | Date of completion of the search | Examiner |
|---|---|---|
| THE HAGUE | 17 March 2000 | Cantarelli, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 99 83 0668

This annex lists the patent family members relating to the patent documents cited in the above-mentioned European search report.
The members are as contained in the European Patent Office EDP file on
The European Patent Office is in no way liable for these particulars which are merely given for the purpose of information.

17-03-2000

| Patent document cited in search report | | Publication date | Patent family member(s) | | Publication date |
|---|---|---|---|---|---|
| JP 59178014 | A | 09-10-1984 | JP 1817932 | C | 27-01-1994 |
|  |  |  | JP 5023085 | B | 31-03-1993 |
| US 5359301 | A | 25-10-1994 | NONE | | |

EPO FORM P0459

For more details about this annex : see Official Journal of the European Patent Office, No. 12/82